# EUROPEAN PATENT SPECIFICATION

(11) **EP 1 833 095 B1**
(45) Date of publication and mention of the grant of the patent: **01.08.2018**
(21) Application number: 06004506.9
(22) Date of filing: 06.03.2006
(51) Int. Cl.: H01L 31/0352

(54) **Photo diode having reduced dark current**
Photodiode mit verringertem Dunkelstrom
Photodiode avec un courant d'obscurité réduit

(43) Date of publication of application: 12.09.2007
(73) Proprietor: ams AG, 8141 Premstätten (AT)
(72) Inventor: Park, Jong Mun, 8010 Graz (AT); Vescoli, Verena, 8010 Graz (AT); Minixhofer, Rainer, 8141 Unterpremstätten (AT)
(74) Representative: Epping - Hermann - Fischer

(56) References cited:
- EP-B1- 1 969 644
- US-A- 3 690 953
- US-A- 5 633 526
- US-A1- 2002 115 300
- US-A1- 2003 122 210
- US-B1- 6 943 409

## Description

Photodiodes have two electrodes - an anode and a cathode - with one or more radiation-sensitive junctions formed in a semiconductor material. They are used for the detection of the power of an incident radiation and for the conversion of the radiation into electrical power.

There are existing several types of photodiodes - pn, pin, or avalanche photo diodes. A pn photodiode has a radiation-sensitive pn junction formed in a semiconductor material. The pin photodiode is characterized by a large intrinsic region between n+- and p+-electrodes, and photons absorbed in this region create electron-hole pairs that are then separated by an electric field. Due to the possibility of tailoring the intrinsic layer to optimize the quantum efficiency and frequency response, the pin photodiode is one of the most common photodetectors. Avalanche photodiodes are operated at high reverse-bias voltages where avalanche multiplication takes place and additional electron-hole pairs are generated by the incident light.

Generally, the built-in voltage across the depletion region results in an electric field with a maximum at the junction and no field outside the depletion region. Any reverse bias applied to cathode and anode adds to the built in voltage and results in a depletion region having a greater width. The electron-hole pairs generated by incident light are swept out by drift from the depletion region and are collected by diffusion from the undepleted region. Characteristic parameters of photodiode to be considered include sensitivity, darkcurrent, rise- and falltime, quantum efficiency, and operating temperature.

A photodiode can be operated with or without an applied reverse bias depending on the application specific requirements. They are referred to as photo-conductive (biased) and photo-voltaic (unbiased) modes. Application of a reverse bias (i.e. cathode positive and anode negative) can greatly improve the speed of response. This is due to an increase of the depletion region width and consequently to a decrease in the junction capacitance.

Applying a reverse bias, however, will increase the dark and noise currents. The photo-voltaic mode of operation (unbiased) is preferred when a photodiode is used in low frequency applications as well as low light level applications together with low dark current level, and the photocurrent in this mode exhibits less variations in responsivity with temperature. One of the most important parameters in each mode of operations is the darkcurrent, which is contributed by diffusion current, generation-recombination current, surface current, and avalanche current. The darkcurrent is the current associated with a photodiode during the operation without any incident light. The darkcurrent increases with temperature and with increasing reverse bias voltage. Additionally, a larger active area or thicker depletion width is associated with a higher darkcurrent.

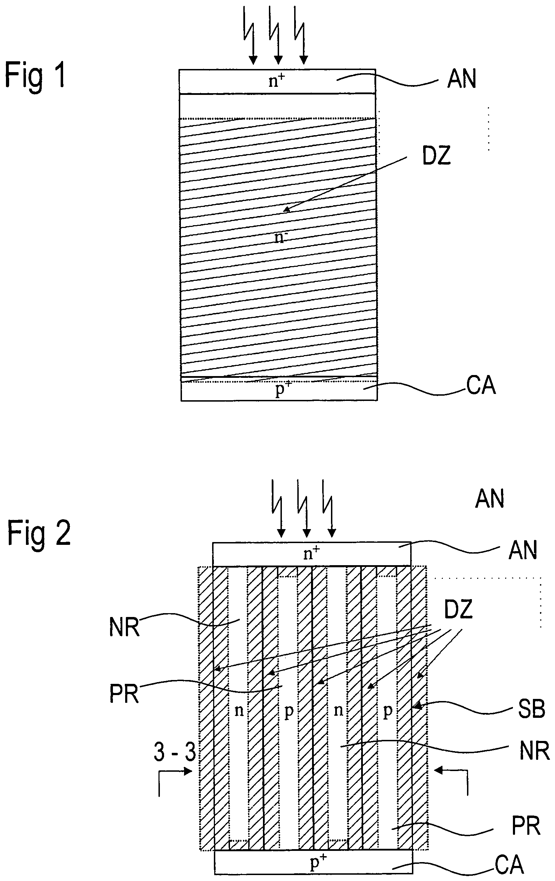

Widely used photodiodes generally have a pn or a pin structure depending on their applications. A pin diode has a lowly doped n-- or p--drift layer between the n+-cathode and the p+-anode. Fig. 1 shows the prior art of a conventional pin-photodiode comprising a n⁺ layer forming the anode AN, a p⁺ layer forming the cathode CA and a weakly doped "intrinsic" layer IL. By varying the doping concentration and thickness of the different layers, one can adjust the darkcurrent and the absorption efficiency of the incident light. In a conventional pin-diode, generally, a thick drift-layer ("intrinsic" layer IL) with low doping concentration is used to absorb in a wide range of wavelength of the incidence light. However, this will drastically increase the depletion zone DZ of the device (as in pin diodes the width of the intrinsic region corresponds often to the width of the depletion region) and a large amount of darkcurrent is generally observed which is not preferable to a low power consumption necessary for sensor applications. With conventional pin-photodiodes it is difficult to improve the trade-off between dark current and absorption efficiency.

The documents US6943409, US2002115300 and US2003122210 disclose photodetectors with junctions orthogonal to the surface of incident light. The document US5633526 discloses a photodetector with alternating p and n regions. It is an object of the invention to provide photo diode having a reduced darkcurrent relative to the above mentioned diodes.

This object is met by a photo diode according to claims 1 or 2. Advantageous embodiments of the invention are subject of the subclaims.
The photo diode comprises a semiconductor body where a highly doped n-region forms a cathode and a highly doped p-region forms an anode. One surface or one surface area of the body is used as an area of light incidence. Besides the highly doped regions there are a p-doped region connected to the anode and a n-doped region connected to the cathode. A pn junction builds up between the p-doped region and the n-doped region. Said doped regions are geometrically arranged in a way such that the pn junction is oriented normally to the area of light incidence.

A depletion zone forms around the junction between the p-doped region and the n-doped region. According to the invention the diode has the advantage that the light can penetrate into the semiconductor body parallel to the junction without leaving the depletion zone before getting absorbed in all cases where a sufficient depth of the doped regions is given. Only light absorbed in the depletion zone along the penetration length can be collected at the anode and cathode by the drift in the electric field to attribute to the response of the photo diode. The length corresponds to the maximum depth the light can penetrate into the semiconductor before getting absorbed. The amount of absorbed light can be selected by choosing a proper length of the depletion zone corresponding to the depth of the doped regions without affecting the width of the depletion zone.

As the penetration depth of light corresponds to the wavelength of incident light a wavelength selectivity can be adjusted without enhancing the darkcurrent. The at least one depletion zone is designed such that there remain non-depleted regions in the semiconductor body.

In diodes known from the art incident light crosses the depletion zone in a direction normal to the junction plane and the maximum penetration depth where absorption can take place corresponds to the width of the depletion zone. But enlarging the depletion zone to enhance the absorption therein will lead to a higher darkcurrent in prior art devices.

In the invention the width of the depletion zone can be optimized without negatively affecting the quantum efficiency of the diode. Therefore, generation-recombination current can be greatly reduced with a photodiode having a junction oriented according to the invention. The maximum absorption length only depends from the geometric dimensions of the p-doped and the n-doped regions.

According to an embodiment of the invention the photo diode comprises an alternating arrangement of n-doped and p-doped regions such that a plurality of pn junctions are formed between same, all junctions being oriented normally with respect to the area of light incidence.

The device can be enlarged in a direction normal to the junction by adding further n-doped and p-doped regions without changing the optimized geometric dimensions of the single respective n- and p-doped regions. Thereby the area of light incidence is enlarged. This allows a shaping of this area according to a desired response of the photo diode (signal strength) or a desired capture cross section or a pixel dimension.

The multiple pn-junctions may be formed by alternatingly stacking a plurality of n-doped and p-doped layers each forming one of said n-doped and p-doped regions. The stacking can be done along a direction parallel to the area of light incidence. As a result a regular arrangement can be received. But it is possible to vary the dimensions of the layers in the stack e.g. the widths of the n-doped and p-doped regions.

According to another way the multiple pn-junctions can be received by forming a plurality of doped columns, each having a doping of the same conductivity type and representing one of said doped regions, in a larger doped region of the inverse conductivity type. Each doped region is oriented with its largest dimension normally to the area of light incidence. By this arrangement the area of the junction can be enlarged allowing to collect a greater part of the charge carriers produced by incident light in the depletion zones between the inverse doping of the columns and their surrounding area.

According to the invention, differently doped columns are arranged checkerboard like to form the semiconductor body, or the doped regions are arranged concentrically in an alternating manner. This may be advantageous if a round area of light incidence is desired or if a given manufacturing method results in such a concentric arrangement.
The cathode can be arranged at a surface of the semiconductor body, covering the plurality of p doped and n doped regions at least partially. Thereby an elongated pn junction between the cathode and the n-doped region results. This elongated part is small relative to the pn junction between n-doped and p-doped regions and may be oriented parallel to the surface of light incidence. This does not withstand the invention as this elongated part forms a depletion zone adding to the depletion zone arranged there below and not restricting the desired absorption length inside the electric field region (depletion zone).
The anode and cathode can be arranged at the same surface each partially covering the plurality of p doped and n doped regions. But it is possible too to arrange the anode at a surface of the semiconductor body opposite to the cathode, and covering the plurality of p doped and n doped regions at least partially.

Cathode and anode may be highly doped layers totally covering opposite surfaces of the semiconductor body. Doping concentration of cathode and anode may be equal or different.

At least one or both of cathode and anode may have the form of a stripe arranged at one edge of the semiconductor body. If both are in the form stripes they are arranged parallel to one another and advantageously on the same surface.

At least the cathode may be arranged on the semiconductor body at the surface of light incidence.

Cathode and anode can be arranged parallel to one another in a stripe form at opposite edges or surfaces of the semiconductor body and connected to a respective of the n-doped or the p-doped region. The at least one junction can be arranged parallel to a virtual connecting line forming the shortest connection between anode and cathode. Thus, anode and cathode are arranged normal to the at least one pn junction. The orientation of the electrical field building up at the junction is also normal to the virtual connection line. This is opposite to known photo diodes showing electrical field vectors parallel to the virtual connection line.

It is a great advantage of the photo diode according to the invention that the penetration depth of light into the semiconductor body normal to the area of incidence can be designed such that the diode is sensitive in a desired range of wavelengths. As light having a longer wavelength corresponds to a higher penetration depth it is possible to design the diode to be sensitive up to the upper end of the sensitivity range of the semiconductor material without any problem. The penetration depth corresponds to the depth where charge carrier pairs can be produced by absorption of incident light and collected in the drift of the electric field, and is embodied by choosing a proper depth of the doped regions or a proper depth of pairs of doped regions respectively building up a pn junction there between. A diode desired to be sensitive in the whole sensitivity range of the semiconductor material of the body has a depth of the doped regions equal to or greater than said penetration depth.
According to another embodiment the semiconductor body comprises a bulk semiconductor material where the doped regions may be formed by selectively doping the body. It is also possible that n-doped and p-doped regions are made from different semiconductor materials.

The photo diode may be a single discrete device. Most preferable is an array of photo diodes each formed according to the invention and assembled on a common semiconductor body e.g. manufactured in or from a common semiconductor wafer. Such an array may be used as a photo detector for imaging purposes or as an optical position sensor.
According to another embodiment the semiconductor body can be arranged on an isolator which may be a cover layer of another bulk semiconductor material functioning as a carrier. Carrier, isolator and semiconductor body may form a SOI substrate (silicon on isolator).

The doped regions may each be formed by proper doping a bulk semiconductor body e.g. by implantation. Alternatively the body may be doped with a proper doping of a first conductivity type such that only regions of the second conductivity type have to be produced actively.
According to another embodiment the doped regions are produced by depositing doped layers of the respective conductivity type one above the other as plane ore concentric layers. The deposition may be done by single or multiple epitaxial growth with proper implantation steps.
According to a further embodiment the doped regions are produced by continued SOI techniques comprising wafer bonding of differently doped wafers.
Preferred embodiments of the present invention will be described in detail with the help of the accompanied drawings.
The drawings are schematics only and not drawn to scale.

### Short description of the drawings

Figure 1 shows a schematic cross section of a prior art pin photo diode
Figure 2 shows a schematic cross section of multiple junction photo diode not being part of the present invention.
Figure 3 shows different multiple junction photo diodes each in a schematic cross section parallel to the area of light incidence, wherein figures 3C and 3D illustrate embodiments of the present invention.
Figure 4 shows a schematic cross section of multiple junction photo diode according to an embodiment of the invention
Figure 5 shows different arrangements of cathode and anode in perspective views
Figure 6 is a diagram showing calculated darkcurrents of embodiments of the invention compared to prior art.

### Detailed description of preferred embodiments

Figure 1 shows the already discussed prior art pin photo diode in a schematic cross section. Its scratched depletion zone DZ is dependent from the thickness of the intrinsic or weakly doped layer IL and of the doping concentration of the anode AN and the cathode CA. Darkcurrent is rising with enhanced thickness of intrinsic or weakly doped layer IL. Light incident through area of incidence is depicted as a flash symbol.
Figure 2 shows a first embodiment of the invention in a schematic cross section. The photo diode has at least one pn junction each formed between a p-doped region PR and a n-doped region NR. The at least one pn junction is oriented normally to the area of incidence i.e. parallel to incident light. At opposite surfaces of the semiconductor body SB are arranged a highly doped cathode CA and a highly doped anode AN respectively, esch at least partially covering the p-doped and a n-doped regions PR, NR. Depletion zones DZ are forming along the pn junctions between differently doped regions PR and NR but do not completely extend over n-doped regions NR and p-doped regions PR. A proper ratio of the summarized width of the depletion zone to the summarized width of regions NR and PR is about 1 : 2. Light may incident as depicted through the top electrode which in the figure is the anode but may also incident from all directions parallel to the pn junction plane, i.e. from the surface opposite as depicted or from a direction vertically to the paper plane. In all cases the pn junction is oriented normal to the area of incidence.

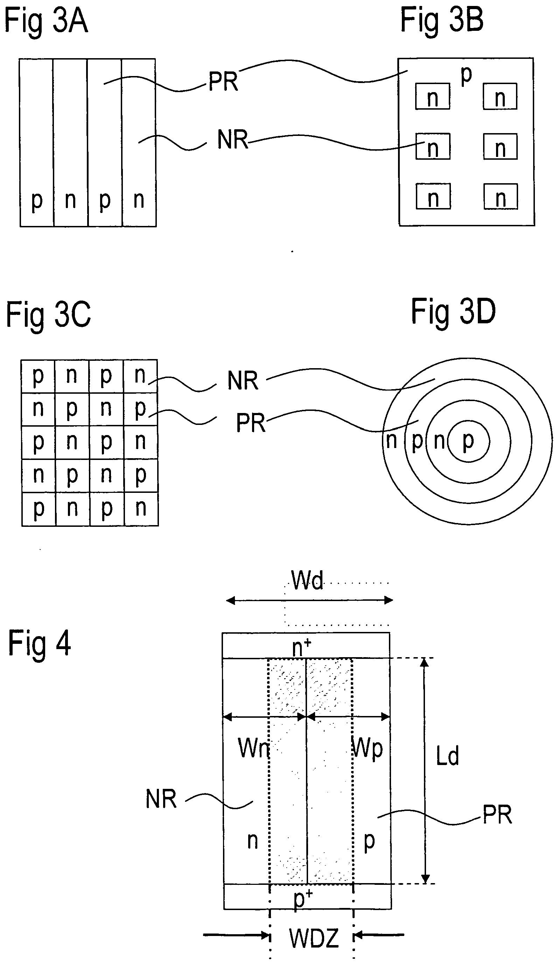

Figure 3 shows different multiple junction photo diodes each in a schematic cross section parallel to the area of light incidence in the depicted plane 3-3 of figure 2.

Figure 3A shows an example, not being part of the present invention, where n-doped regions NR and p-doped regions PR are formed as respectively doped layers stacked one above another. Stacking may be done by epitaxially growing a desired number of doped regions one above another.

The doping of a respective layer can also be done after depositing before growing the next layer. It is possible too to form differently doped regions in the same semiconductor body by masked doping procedures. Another method is to epitaxially grow a first type of doped regions selected from NR and PR in the cut-outs of a structured mask and thereafter removing the mask and after removing the mask epitaxially filling the holes left with an inversely doped semiconductor material.

Figure 3B shows an example not being part of the present invention, where n-doped regions NR are forming an array of columns arranged in a larger p-doped regions PR. It is also possible to arrange p-doped columns in a larger n-doped regions NR. The cross section area of the columns need not be quadratic but can be of any form preferably of a regular polyeder or a circle. These columns can be manufactured by etching holes into a semiconductor body and filling them by epitaxially growing a respectively doped material therein. Masked doping or masked epitaxial growth is also possible.

Figure 3C shows an embodiment of the present invention, comprising n-doped columns and p-doped columns each forming a respectively doped region, and together forming a checkerboard like arrangement in the semiconductor body. The columns of both kinds are equally sized.

A further embodiment of the present invention is shown in figure 3D. The n-doped regions NR and the p-doped regions PR are formed as respectively doped layers concentrically arranged in an alternating manner. A round cross section results.

Figure 4 shows some geometrical relations in a photodiode with p-n junctions oriented normally to the area of incidence. The length of the depletion zone measured parallel to incident light accords to the depth Ld of the doped regions PR and NR. The width Wn of n-doped regions NR and the width Wp of p-doped regions PR can be chosen to be equal or different. Also the doping concentration of regions NR and PR can be chosen equal or different. Depletion layer width WDZ can be easily controlled by adjusting the width of n- and p-doped regions respectively or by adjusting their doping concentration. The width WDZ may be chosen to be in the same order of magnitude like the width Wn or Wp of the doped regions PR and NR. Thus the ratio of WDZ to the total width Wd of the both doped regions PR and NR can be varied by varying the doping concentrations and bias conditions.

Depletion layer width WDZ can be chosen to be 0,05 to 1 *µ*m but can amount up to 3 *µ*m and more without departing from the scope of the invention. No complete charge balance is assumed between n-region NR and p-region PR, and the main purpose of the suggested device structure is to obtain a shallow partially depleted region in the bulk semiconductor body while keeping a desired (sufficient) length Ld of the depletion zone DZ.

The length Ld can be adjusted dependent from the wavelength range the diode should correspond to. Ld can amount for example from 0,1 *µ*m to about 20 *µ*m for a crystalline silicon semiconductor body. Other materials having another transparency, bandgap or light sensitivity need other dimensions. A larger Ld enlarges the range of wavelengths the diode is sensitive for. A larger Ld also enhances the response and the quantum efficiency of the diode.

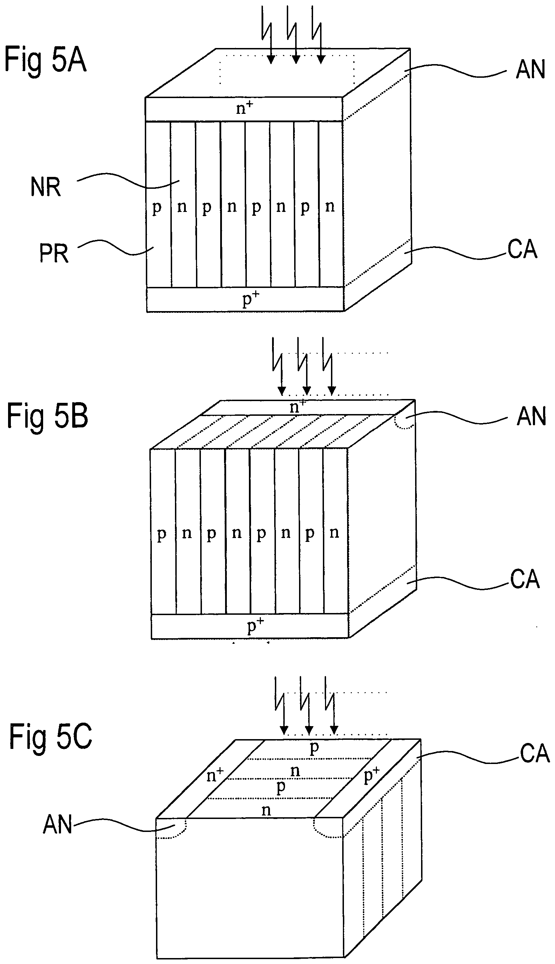

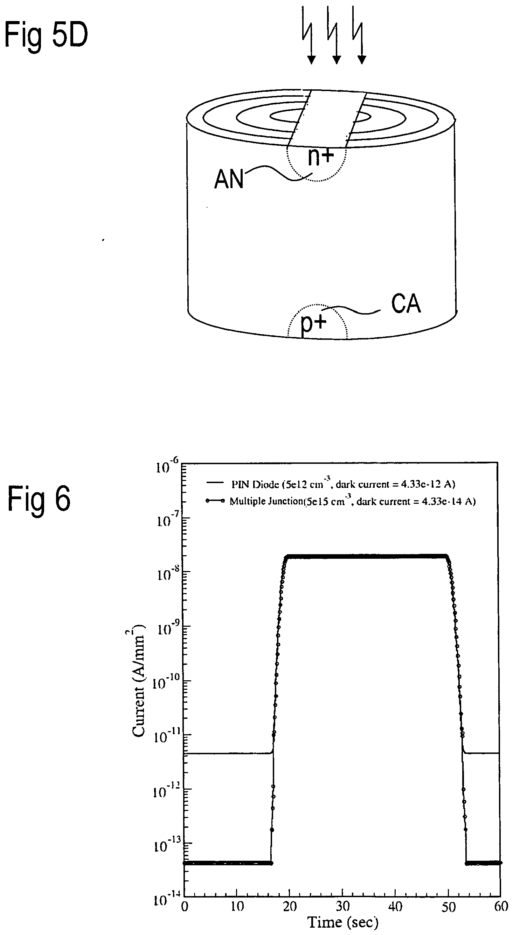

Fig. 5 shows the several types of anode and cathode structures of multiple-junction photodiodes. With the suggested structure one can control the trade-off between dark current and absorption efficiency of photodiodes.

In figure 5A cathode CA and anode AN are both formed as layers arranged on opposite surfaces of the semiconductor body and completely covering p-doped and n-doped regions PR, NR.

In figure 5B only the cathode CA is formed as a layer completely covering a surface of the semiconductor body e.g. the bottom surface opposite to the area of light incidence. The anode AN has a stripe form and is arranged at an edge of the body opposite to the anode layer and only partially covering p-doped and n-doped regions PR, NR. It is advantageous that the depletion zones DZ are directly bordering the area of light incidence where no anode covers this surface. Thus, absorption at or near the top surface can take place in the depletion zones DZ to contribute to the response of the photo diode. Thus, light in the short wavelength range of the sensitivity range of the semiconductor can absorbed near the surface in the depletion zone and the arrangement thus has a better sensitivity to shorter wavelengths than the arrangement of figure 5A where the depletion zones DZ do not border the incidence area.
In figure 5C the anode AN and the cathode CA as well have a stripe form arranged at opposite edges of the arrangement on the same surface e.g. on the area of light incidence.
In figure 5D the anode AN and the cathode CA as well have a stripe form arranged at opposite surfaces of the arrangement. This embodiment is most suited for the concentric arrangement of doped regions but may be used too for an arrangement according to figure 3A. Vice versa an arrangement according to figure 3D may have electrodes formed as layers arranged on opposite surfaces of the semiconductor body completely covering p-doped and n-doped regions PR, NR.
In the following the properties of a photodiode according to the invention are analyzed by simulation calculation and compared to the respective properties of a pin photodiode known from the art.
Device parameters are chosen as follows:
The conventional photo diode has a pin diode structure with an abrupt junction. The doping concentration ND of the intrinsic layer IL is 5e12 cm⁻³.
The multiple-junction pn diode has a doping concentration NR and PR of the doped regions NR, PR of 5e15 cm⁻³.
The depth Ld of doped regions PR,NR and width of intrinsic layer IL are equal: Ld = 20.0 *µ*m.
Wp = Wn = 2.5 *µ*m for multiple-junction.
Wd = Wn + Wp = 5 *µ*m for conventional structure.
Total areas of light incidence: 1.0 mm² in both cases respectively.
Bias condition: 0 V

**Results of the calculations**

| Device | Ld (µm ) | Wd (µm) | Depletion width W (µm) | Depletion area A (µm²) | I_{dark} = I_{gen} + I_{diff} (A/mm²) |
|---|---|---|---|---|---|
| PIN diode (ND = 5e12 cm⁻³) | 20 | 5 | Vertical: 9.2 | 5.0 x 9.2 = 46 | 4.33 e-12 |
| | | | Lateral: 5.0 | | |
| Multiple-junction (ND = NA = 5e15 m⁻³) | 20 | 2.5 (Wn = Wp) | Vertical: 20.0 | 0.41 x 20 = 8.2 | 4.33e-14 |
| | | | Lateral: 0.41 | | |

From the calculations it can be seen that the darkcurrent of the multiple-junction pn diode according to the invention has a very low darkcurrent of 4.33e-14 A/mm² being two orders of magnitude lower than the darkcurrent of the comparative diode known from the art. Thus, the multiple-junction pn diode is superior for having a better signal/noise ratio. The diode is more sensitive, has an enhanced sensitivity range and a better quantum efficiency.

The calculated graphs of the responses of the diode according to the embodiment and of the comparison example are shown in figure 6. It is assumed that in both cases a light pulse of the same wavelength impinges onto the diodes which are driven in the photovoltaic mode without bias. A response in the saturation area of response results. As expected the diagram shows that both diodes have the same response at incident light. A recent difference is the above mentioned reduced darkcurrent which is much lower in the case of the multiple junction diode.

### Reference symbols used in the drawings

- SB: semiconductor body
- PR: p-doped region
- NR: n-doped region
- Wp: width of p-doped region
- Wn: width of n-doped region
- WDZ: width of depletion zone
- Wd: width of PR plus NR
- Ld: length of doped region (length of junction)
- CA: cathode
- AN: anode
- DZ: depletion zone
- IL: Intrinsic or weakly doped layer

## Claims

1. A photodiode comprising:
- a semiconductor body (SB);
- a surface of the semiconductor body forming an area of light incidence;
- a highly n-doped region forming a cathode (CA);
- a highly p-doped region forming an anode (AN);
- a plurality of further n-doped regions (NR) connected to the cathode;
- a plurality of further p-doped regions (PR) connected to the anode;
- the further n-doped regions (NR) and the further p-doped regions (PR) being adjacent to one another forming a plurality of separate areas of pn-junctions; and
- the areas of pn-junctions being oriented normally to the area of light incidence,
**characterized in that**
- the further n-doped regions (NR) are formed of a plurality of n-doped columns;
- the further p-doped regions (PR) are formed of a plurality of p-doped columns; and
- the n-doped columns and the p-doped columns are arranged in the shape of a checkerboard.

2. A photodiode comprising:
- a semiconductor body (SB);
- a surface of the semiconductor body forming an area of light incidence;
- a highly n-doped region forming a cathode (CA);
- a highly p-doped region forming an anode (AN);
- a plurality of further n-doped regions (NR) connected to the cathode;
- a plurality of further p-doped regions (PR) connected to the anode;
- the further n-doped regions (NR) and the further p-doped regions (PR) being adjacent to one another forming a plurality of separate areas of pn-junctions; and
- the areas of pn-junctions being oriented normally to the area of light incidence,
**characterized in that**
- the further n-doped regions (NR) encompass a plurality of n-doped layers having the shape of hollow cylinders of different diameters;
- the further p-doped regions (PR) encompass a plurality of p-doped layers having the shape of hollow cylinders of different diameters; and
- the n-doped layers and the p-doped layers are arranged in alternating concentric fashion.

3. The photodiode of one of claims 1 or 2, wherein
the cathode (CA) and the anode (AN) are arranged on opposite surfaces of the semiconductor body (SB), covering the further n-doped regions (NR) and the further p-doped regions (PR) at least partially; and
the areas of pn-junctions are oriented normally to these surfaces.

4. The photodiode of claim 1, wherein
the cathode (CA) or the anode (AN) is arranged in striplike fashion at an edge of the semiconductor body (SB).

5. The photodiode of claim 1, wherein
the cathode (CA) and the anode (AN) are arranged in striplike fashion at opposite edges of the arrangement on the same surface of the semiconductor body (SB).

6. The photodiode of claim 2, wherein
the semiconductor body (SB) is a cylinder; and
the cathode (CA) and the anode (AN) are arranged in striplike fashion at opposite planar surfaces of the semiconductor body along a diameter of the surface.

## Patentansprüche

1. Fotodiode, Folgendes umfassend:
- einen Halbleiterkörper (SB);
- eine Fläche des Halbleiterkörpers, die einen Lichteinfallsbereich bildet;
- eine stark n-dotierte Zone, die eine Kathode (CA) bildet;
- eine stark p-dotierte Zone, die eine Anode (AN) bildet;
- mehrere weitere n-dotierte Zonen (NR), die an die Kathode angeschlossen sind;
- mehrere weitere p-dotierte Zonen (PR), die an die Anode angeschlossen sind;
- wobei die weiteren n-dotierten Zonen (NR) und die weiteren p-dotierten Zonen (PR), die aneinander angrenzen, mehrere separate Bereich von pn-Übergängen bilden; und
- wobei die Bereiche der pn-Übergänge senkrecht zum Lichteinfallsbereich ausgerichtet sind,
**dadurch gekennzeichnet, dass**
- die weiteren n-dotierten Zonen (NR) aus mehreren n-dotierten Säulen gebildet sind;
- die weiteren p-dotierten Zonen (PR) aus mehreren p-dotierten Säulen gebildet sind; und
- die n-dotierten Säulen und die p-dotierten Säulen in Form eines Schachbretts angeordnet sind.

2. Fotodiode, Folgendes umfassend:
- einen Halbleiterkörper (SB);
- eine Fläche des Halbleiterkörpers, die einen Lichteinfallsbereich bildet;
- eine stark n-dotierte Zone, die eine Kathode (CA) bildet;
- eine stark p-dotierte Zone, die eine Anode (AN) bildet;
- mehrere weitere n-dotierte Zonen (NR), die an die Kathode angeschlossen sind;
- mehrere weitere p-dotierte Zonen (PR), die an die Anode angeschlossen sind;
- wobei die weiteren n-dotierten Zonen (NR) und die weiteren p-dotierten Zonen (PR), die aneinander angrenzen, mehrere separate Bereich von pn-Übergängen bilden; und
- wobei die Bereiche der pn-Übergänge senkrecht zum Lichteinfallsbereich ausgerichtet sind,
**dadurch gekennzeichnet, dass**
- die weiteren n-dotierten Zonen (NR) mehrere n-dotierte Schichten mit der Form von Hohlzylindern unterschiedlicher Durchmesser umfassen;
- die weiteren p-dotierten Zonen (PR) mehrere p-dotierte Schichten mit der Form von Hohlzylindern unterschiedlicher Durchmesser umfassen; und
- die n-dotierten Schichten und die p-dotierten Schichten abwechselnd konzentrisch angeordnet sind.

3. Fotodiode nach einem der Ansprüche 1 oder 2, wobei die Kathode (CA) und die Anode (AN) auf entgegengesetzten Flächen des Halbleiterkörpers (SB), die weiteren n-dotierten Zonen (NR) und die weiteren p-dotierten Zonen (PR) zumindest teilweise abdeckend angeordnet sind; und
die Bereiche von pn-Übergängen senkrecht zu diesen Flächen ausgerichtet sind.

4. Fotodiode nach Anspruch 1, wobei
die Kathode (CA) oder die Anode (AN) streifenartig an einem Rand des Halbleiterkörpers (SB) angeordnet ist.

5. Fotodiode nach Anspruch 1, wobei
die Kathode (CA) und die Anode (AN) streifenartig an entgegengesetzten Rändern der Anordnung auf derselben Fläche des Halbleiterkörpers (SB) angeordnet sind.

6. Fotodiode nach Anspruch 2, wobei
es sich bei dem Halbleiterkörper (SB) um einen Zylinder handelt; und
die Kathode (CA) und die Anode (AN) streifenartig an entgegengesetzten planen Flächen des Halbleiterkörpers entlang eines Durchmessers der Fläche angeordnet sind.

## Revendications

1. Photodiode comprenant :
- un corps semiconducteur (SB) ;
- une surface du corps semiconducteur formant une aire d'incidence de lumière ;
- une région fortement n-dopée formant une cathode (CA) ;
- une région fortement p-dopée formant une anode (AN) ;
- une pluralité de régions n-dopées (NR) supplémentaires connectées à la cathode ;
- une pluralité de régions p-dopées (PR) supplémentaires connectées à l'anode ;
- les régions n-dopées (NR) supplémentaires et les régions p-dopées (PR) supplémentaires adjacentes les unes aux autres formant une pluralité d'aires séparées de jonctions pn ; et
- les aires de jonctions pn étant orientées normalement par rapport à l'aire d'incidence de lumière,
**caractérisée en ce que**
- les régions n-dopées (NR) supplémentaires sont composées d'une pluralité de piliers n-dopés ;
- les régions p-dopées (PR) supplémentaires sont composées d'une pluralité de piliers p-dopés ; et
- les piliers n-dopés et les piliers p-dopés sont agencées sous la forme d'un damier.

2. Photodiode comprenant :
- un corps semiconducteur (SB) ;
- une surface du corps semiconducteur formant une aire d'incidence de lumière ;
- une région fortement n-dopée formant une cathode (CA) ;
- une région fortement p-dopée formant une anode (AN) ;
- une pluralité de régions n-dopées (NR) supplémentaires connectées à la cathode ;
- une pluralité de régions p-dopées (PR) supplémentaires connectées à l'anode ;
- les régions n-dopées (NR) supplémentaires et les régions p-dopées (PR) supplémentaires adjacentes les unes aux autres formant une pluralité d'aires séparées de jonctions pn ; et
- les aires de jonctions pn étant orientées normalement par rapport à l'aire d'incidence de lumière,
**caractérisée en ce que**
- les régions n-dopées (NR) supplémentaires comprennent une pluralité de couches n-dopées ayant la forme de cylindres creux de différents diamètres ;
- les régions p-dopées (PR) supplémentaires comprennent une pluralité de couches p-dopées ayant la forme de cylindres creux de différents diamètres ; et
- les couches n-dopées et les couches p-dopées sont agencées de manière concentrique en alternance.

3. La photodiode de l'une des revendications 1 ou 2, sachant que
la cathode (CA) et l'anode (AN) sont agencées sur des surfaces opposées du corps semiconducteur (SB), couvrant au moins partiellement les régions n-dopées (NR) supplémentaires et les régions p-dopées (PR) supplémentaires ; et
les aires de jonctions pn sont orientées normalement par rapport à ces surfaces.

4. La photodiode de la revendication 1, sachant que
la cathode (CA) ou l'anode (AN) est agencée en forme de bande au niveau d'un bord du corps semiconducteur (SB).

5. La photodiode de la revendication 1, sachant que
la cathode (CA) et l'anode (AN) sont agencées en forme de bande au niveau de bords opposés de l'agencement sur la même surface du corps semiconducteur (SB).

6. La photodiode de la revendication 2, sachant que
le corps semiconducteur (SB) est un cylindre ; et
la cathode (CA) et l'anode (AN) sont agencées en forme de bande au niveau de surfaces planes opposées du corps semiconducteur le long d'un diamètre de la surface.
